# EUROPÄISCHE PATENTSCHRIFT

(11) **EP 1 439 396 B1**
(45) Veröffentlichungstag und Bekanntmachung des Hinweises auf die Patenterteilung: **19.08.2009**
(21) Anmeldenummer: 04100074.6
(22) Anmeldetag: 12.01.2004
(51) Int. Cl.: G01R 31/12, G01R 31/02

(54) **Verfahren zur Analyse und Überwachung des Teilentladungsverhaltens eines elektrischen Betriebsmittels**
Method for the analysis and monitoring of the partial discharge behavior of an electrical operating means
Procédé d'analyse et de surveillance du comportement de la décharge partielle d'une installation électrique

(30) Priorität: 15.01.2003 CH 572003
(43) Veröffentlichungstag der Anmeldung: 21.07.2004
(73) Patentinhaber: Alstom Technology Ltd, 5400 Baden (CH)
(72) Erfinder: Freisleben, Bernd, 61118, Bad Vilbel (DE); Hoof, Martin, 67661, Kaiserslauten (DE); Kulla, Alban, 35041, Marburg (DE); Mustafaraj, Eniana, 35041, Marburg (DE); Peters, Michael, 79790, Küssaberg (DE); Wendel, Christoph, 79725, Laufenburg (DE)

(56) Entgegenhaltungen:
- EP-A- 1 094 325
- GB-A- 2 368 733
- US-A- 6 088 658
- HOZUMI N ET AL: "Time-lag measurement of vold discharges for the clarification of the factor for partial discharge pattern" 2000 IEEE, Bd. 2, 15. Oktober 2000 (2000-10-15), Seiten 717-720, XP010522116
- PETKOVIC I ET AL: "Measuring system for partial discharge" INSTRUMENTATION AND MEASUREMENT TECHNOLOGY CONFERENCE, 1996. IMTC-96. CONFERENCE PROCEEEDINGS. QUALITY MEASUREMENTS: THE INDISPENSABLE BRIDGE BETWEEN THEORY AND REALITY., IEEE BRUSSELS, BELGIUM 4-6 JUNE 1996, NEW YORK, NY, USA,IEEE, US, 4. Juni 1996 (1996-06-04), Seiten 426-429, XP010163915 ISBN: 0-7803-3312-8

## Beschreibung

### TECHNISCHES GEBIET

Die vorliegende Erfindung bezieht sich auf das Gebiet der Verfahren zur Analyse und/oder Überwachung des Teilentladungsverhaltens eines elektrischen Betriebsmittels, insbesondere in dessen zeitlicher Entwicklung.

### STAND DER TECHNIK

Als Teilentladungen (TE) werden diejenigen elektrischen Entladungsphänomene bezeichnet, die nicht zum Zusammenbruch der gesamten Isolierstrecke führen. Sie breiten sich lediglich in einem räumlich begrenzten Gebiet aus.

Teilentladungen finden stets innerhalb eines Gasraumes oder auch an Grenzflächen zwischen Gasraum und anderen Oberflächen statt. Sie können auch in festen Isolationen als Folge stark inhomogener Feldverhältnisse auftreten. Sie treten dort jedoch in der Regel weit oberhalb der technischen Einsatzgrenzen der Isolationsmaterialien auf, und sind daher für den normalen Betriebsfall im Allgemeinen nicht relevant.

Teilentladungen bilden sich als Folge inhomogener Feldverhältnisse, z.B. aufgrund unterschiedlicher Dielektrizitätskonstanten der Isolierstoffe, und der sich daraus ergebenden möglichen lokalen Überbelastung einzelner Isolierstoffpartien, aus.

Solche Teilentladungen führen stets zur Schädigung der sie umgebenden Isolation. Inwieweit diese Schädigung zu einer signifikanten Alterung des umgebenden Mediums führt, hängt hingegen von einer Vielzahl von Parametern ab.

So können die Teilentladungen in ihrer Intensität derart energiearm sein, dass der Grad der Schädigung, in technisch relevanten Zeiträumen gemessen, vernachlässigt werden kann. Ebenso kann das umgebende Medium (Isolierstoff) derart gegenüber Teilentladungen resistent sein, dass die Schädigungswirkung, innerhalb relevanter Zeiträume, ebenso vernachlässigbar ist, selbst bei erhöhter Teilentladungsintensität.

Ebenso kann der Isolierstoff so beschaffen sein, dass geschädigte "Partien", z.B. durch natürliche Konvektion, vom Ort der Entladungstätigkeit abgeführt werden. Dies ist bei zirkulierender Luft als Isolierstoff oder aber auch bei zirkulierenden Flüssigkeiten möglich und wird dort auch technisch genutzt.

Die Erfassung solcher Entladungen kann auf verschiedene Arten erfolgen wie z.B. durch optische und elektromagnetische Detektionsverfahren oder auch durch akustische Verfahren. Zur Erfassung von Teilentladungen innerhalb räumlich ausgedehnter Anordnungen hat sich die elektrische Erfassung dieser Entladungen durch Messung des Teilentladungsstromes durchgesetzt. Umschlossene Isolierstoffpartien können nur durch Messungen der elektrischen Signale ausreichend sicher überwacht werden.

Messgeräte zur Erfassung solcher Phänomene sind weit verbreitet. Sie sind in der Lage, die Teilentladungstätigkeit über einen bestimmten Zeitraum aufzunehmen und darzustellen. Ebenso sind solche Geräte bei Implementierung einer Fernsteuerbarkeit in der Lage, Messungen auf Anfrage bzw. periodische Messungen selbständig durchzuführen. Messungen werden auch häufig periodisch durchgeführt, indem ein transportables Teilentladungsmessgerät in regelmässigen zeitlichen Abständen an das Messobjekt geschaltet wird.

Diesen Verfahren ist häufig gemeinsam, dass die Messungen, aufgrund der grossen anfallenden Datenmengen, im Allgemeinen nur in grösseren Zeitabständen, z.B. alle 6 Monate, durchgeführt werden können. Zudem werden solche Messungen häufig von speziell geschultem Personal vor Ort durchgeführt, so dass die Wiederholungsmessungen auch aus Kostengründen nicht zu häufig stattfinden können.

Wesentlich ist aber auch, dass sich sehr viele Teilentladungsprozesse relativ langsam entwickeln, so dass häufige Wiederholungsmessungen nicht in allen Fällen zu rechtfertigen sind.

Nachteile periodischer Messungen sind:
1. Schnelle Änderungen im Teilentladungsverhalten werden mitunter nicht erfasst. Somit stehen diese, unter Umständen wichtigen, Informationen nicht zur Verfügung.
2. Es stehen Informationen zum Teilentladungsverhalten nicht zu allen möglichen Betriebszuständen (Last, Temperatur, Vibration, .....) zur Verfügung. Dies kommt ebenso einem Verlust bestimmter, zum Teil wichtiger, Informationen gleich.
3. Massnahmen aufgrund sich ändernden Teilentladungsverhaltens werden unter Umständen zu spät eingeleitet oder aber kritische Schädigungen werden zu spät erkannt.

Abhilfe schaffen Systeme, die das Teilentladungsverhalten kontinuierlich beobachten und
1. die Daten komprimiert abspeichern bzw. nur über kurze Intervalle erfassen und speichern oder Systeme,
2. die das aktuell gemessene Teilentladungsverhalten einem vorgeschalteten Prozess unterziehen und aus diesem Prozess einige wenige Kennwerte beziehen, die das Teilentladungsverhalten ausreichend repräsentieren, um diese Kennwerte dann abzuspeichern. Diese Kennwerte können anschliessend herangezogen werden, um weitere Aktionen auszulösen.

Verfahren, das gemessene Teilentladungsverhalten einem vorgeschalteten Prozess zu unterziehen, sind in den US Patenten US 6,088,658 bzw. US 6,192,317 geschildert. In diesen Patenten wird ein Verfahren dargestellt, das prinzipiell nach folgendem Schema arbeitet:
1. Ein System wird mit einer Anzahl von Teilentladungsdaten trainiert um Klassen für bekannte Fehlertypen zu bilden.
2. Der Zustand der elektrischen Betriebsmittel, von denen diese Teilentladungsdaten gesammelt wurden, muss bekannt sein.
3. Zum Trainieren des Systems sind mindestens zwei Datensätze notwendig: Die Teilentladungsdaten einer in irgend einer Weise geschädigten Isolation, sowie die Teilentladungsdaten zu einem Betriebsmittel mit einer gesunden Isolation. Mit diesen Daten werden wenigstens zwei Klassen gebildet, der Schädigungszustand muss jeweils bekannt sein.
4. Klassen zu bilden bedeutet:
   a) Es wird ein Isolationszustand ermittelt, der für die Klasse repräsentativ ist, und der im Mittel diesen Isolationszustand (Klasse) darstellt, und
   b) Es sind Schwellenwerte definiert, innerhalb derer diese Klasse repräsentativ ist.
5. Nachfolgend werden dem System weitere Teilentladungsdaten zugeführt, um weitere Klassen bekannter Isolationszustände zu bilden und um zu diesen wiederum Schwellenwerte zu gewinnen. Das System ist jedoch prinzipiell in der Lage, mit nur 2 Klassen auszukommen.
6. Um den Zustand einer Isolation mit Hilfe der Teilentladungsmessung zu bestimmen, wird der Abstand (Distanz) der aktuellen Teilentladungsmessung mit der repräsentativen Teilentladungsmessung (repräsentative Messung) einer jeden zuvor gebildeten Klasse gewonnen.
7. Nach dem Vergleich dieser berechneten Distanzen mit den zugehörigen Schwellenwerten wird die aktuelle Messung der Klasse zugewiesen, deren Abstand zur repräsentativen Messung am geringsten ist, sofern der Abstand zur Klasse innerhalb des Schwellwertes liegt. Ansonsten gilt die aktuelle Messung als nicht gültig oder als nicht zuzuordnen.

Gekennzeichnet sind Verfahren, die diese oder ähnliche Ansätze verwenden, durch folgende Eigenschaften:
1. Die Klassen müssen mit einer Anzahl von bekannten Teilentladungsdaten gebildet worden sein, bevor zuverlässige Ausgabewerte erwartet werden können. Diese Anzahl von repräsentativen Daten ist insbesondere wichtig, um die Schwellen festzulegen, innerhalb derer die Klassen erkannt werden. Wichtig ist dies auch dann, wenn die Teilentladungsdaten z.B. durch Störer und Rauschen überlagert sind, die jeweils die Klassenbildung erschweren.
2. Es werden nur Isolationszustände erkannt, die zuvor für die Klassenbildung trainiert wurden.
3. Wurde beim Training der Isolationszustand nicht korrekt berücksichtigt, so wird der Ausgabewert aus diesem Prozess stets fehlerbehaftet sein, bzw. den fehlerhaft gebildeten Klassen zugewiesen.
4. Ein Vergleich des Teilentladungsverhaltens unterschiedlicher elektrischer Betriebsmittel ist nicht immer möglich, sofern die Peripherien der Betriebsmittel bzw. die Betriebsmittel selbst nicht identisch sind. Daher kann die Datenbasis, die zur Bildung der Klassen herangezogen wird, dünn bzw. wenig sicher sein.
5. Repräsentieren die gebildeten Klassen jedoch Maschinen unterschiedlicher Bauart und unterschiedlicher Peripherie, so wird automatisch auf eine sehr grosse Datenbasis zugegriffen, welche die Qualität der Aussagen erhöht.
6. Sind ausreichend viele Fehlertypen zur Bildung verschiedener Klassen herangezogen worden, so können auch die Fehlertypen differenziert erkannt werden.
7. Die gewonnen Ergebnisse aus der Klassenbildung und aus dem Vergleich mit neu gewonnenen Teilentladungsdaten können herangezogen werden, die Teilentladungsgeschichte ("history") eines elektrischen Betriebsmittels zu dokumentieren, und eine zukünftige Prognose abzugeben.

### DARSTELLUNG DER ERFINDUNG

Es ist entsprechend Aufgabe der vorliegenden Erfindung, ein verbessertes Verfahren zur Analyse und/oder Überwachung des Teilentladungsverhaltens eines elektrischen Betriebsmittels zur Verfügung zu stellen. Insbesondere geht es dabei darum, die zeitliche Entwicklung des Teilentladungsverhaltens zu überwachen. Dabei werden typischerweise entsprechende Teilentladungsdaten in Prozesszustandsmatrizen festgehalten, in welchen jeweils in einem Matrixelement der Prozesszustandsmatrix die Amplitude einer Teilentladung, deren Phasenwinkel und deren Auftretenshäufigkeit abgebildet sind. So beispielsweise indem die Amplitude als Funktion des Phasenwinkels abgebildet ist, wobei jedem Matrixelement ausserdem eine zugehörige Auftretenshäufigkeit zugeordnet ist. Diese Darstellung wird üblicherweise als phasenaufgelöstes Teilentladungsmuster, oder im Englischen als "phase resolved partial discharge pattern", PRPD, bezeichnet. Typischerweise werden derartige Daten dargestellt, indem die Amplitude als Funktion des Phasenwinkels aufgetragen wird, und indem als Codierung der dritten Dimension, der Auftretenshäufigkeit , eine bestimmte, codierende Einfärbung oder Graustufung für jeden Datenpunkt verwendet wird. Alternativ ist es u.a. möglich, diese Daten im Raum so darzustellen, dass ein Relief gebildet wird (sog. Wasserfalldarstellung), bei welchem beispielsweise grosse Auftretenshäufigkeiten durch einen hoch über einer Normalenebene angeordneten Punkt dargestellt werden, und entsprechend niedrige Häufigkeiten niedrig über der Normalenebene. Ausserdem sind Darstellungen in Polarkoordinaten und andere möglich.

Als Lösung wird in dieser Offenbarung ein Verfahren vorgestellt, welches einen weiteren Ansatz aufzeigt, das Teilentladungsverhalten eines elektrischen Betriebsmittels zu beurteilen. Diese Beurteilung beruht auf dem Vergleich des aktuellen Zustandes des Betriebsmittels mit wenigstens einem früheren bekannten und von einem menschlichen Experten bewerteten Zustand des Betriebsmittels, welcher numerisch durch ein (oder mehrere) initiale Zustandsparameter beschrieben wird. Die von dem Vergleich produzierten Daten können ebenso zu einem Trending des Teilentladungsverhaltens herangezogen werden.

Der wesentliche Unterschied zum zuvor beschriebenen Verfahren besteht darin, dass das Teilentladungsverhalten nur des zu betrachtenden elektrischen Betriebsmittels Verwendung findet, um den Zustand von dessen Isolation zu beurteilen. Dieses Verfahren ist daher nicht auf die Bildung von Klassen angewiesen, um den Zustand zu beurteilen, sondern stützt sich wesentlich auf die Erfahrung menschlicher Experten bei der Beurteilung des Isolationszustandes bei Beginn des Beobachtungszeitraumes und zu jedem weiteren Beobachtungszeitpunkt.

Die Aussagen stützen sich somit nicht in erster Linie auf die Erkennung der spezifischen Fehlerquellen, sondern beschränken sich im wesentlichen auf die Erkennung wesentlicher Veränderungen im Teilentladungsverhalten.

Konkret besteht die vorliegende Lösung darin, zu einem ersten Zeitpunkt einen Teilentladungsprozesszustand in einer ersten Prozesszustandsmatrix zu erfassen, und zu einem späteren Zeitpunkt einen weiteren Teilentladungsprozesszustand in einer weiteren Prozesszustandsmatrix zu erfassen. Anschliessend werden zur Analyse und/oder Überwachung die erste und die zweite Prozesszustandmatrix unter Zuhilfenahme von Vergleichs- und Normierungsverfahren verglichen.

Grundsätzlich kann der zum ersten Zeitpunkt erfasste Teilentladungsprozesszustand als Basis für den Vergleich mit allen später erfassten Prozesszuständen dienen. Alternativ kann aber auch jeder zu einem beliebigen Zeitpunkt erfasste Teilentladungsprozesszustand als Basis für den Vergleich mit allen später erfassten Prozesszuständen Verwendung finden.

Insbesondere in Bezug auf eine vereinfachte Interpretation und Fehlerlokalisierung, aber auch in Bezug auf zu speichernde Datenvolumina, erweist es sich gemäss einer ersten bevorzugten Ausführungsform als vorteilhaft, jeweils aus den Prozesszustandsmatrizen zunächst, insbesondere normierte, Zustandsparameter zu ermitteln, und anschliessend zur Analyse und/oder Überwachung der Isolationszustände diese Zustandsparameter zu vergleichen, respektive miteinander zu korrelieren. Es kann sich dabei um einen oder mehrere Zustandsparameter handein. Der zeitliche Verlauf von aus verschiedenen weiteren Prozesszustandsmatrizen ermittelten Zustandsparametern kann ausserdem zur Bewertung der zeitlichen Änderung respektive zur Prognose der vermuteten weiteren zeitlichen Änderung des Teilentladungsverhaltens hinzugezogen werden. Der oder die Ausgabewerte aus den geführten Vergleichen der Zustandsparameter können u.a. vorteilhaft genutzt werden, um Reparatur- und Instandhaltungsmassnahmen einzuleiten bzw. um aus dem zeitlichen Verlauf der Zustandsparameter diese Massnahmen zu definieren.

Gemäss einer weiteren bevorzugten Ausführungsform der Erfindung erfahren die einzelnen Matrixelemente je nach Amplitude eine unterschiedliche Gewichtung und/oder Normierung, bevor sie dem Vergleichs- und Normierungsverfahren zugeführt werden. Alternativ oder zusätzlich ist es möglich, nicht die Amplitude sondern den Phasenwinkel oder die Auftretenshäufigkeit als Gewichtungsbasis zu verwenden.

Eine andere bevorzugte Ausführungsform zeichnet sich dadurch aus, dass das Vergleichsverfahren einen Schritt umfasst, in welchem Ähnlichkeitswerte gebildet werden, die den Unterschied zwischen den Prozesszustandsmatrizen wiedergeben, wobei die Prozesszustandsmatrizen in einer Darstellung der Amplituden als Funktion des Phasenwinkels und einer Codierung jedes derartigen Bildpunktes in Funktion der Auftretenshäufigkeit visualisiert sind (PRPD-Darstellung).

Besonders einfach lassen sich die Vergleiche verschiedener Prozesszustandsmatrizen dann realisieren, wenn in der PRPD-Darstellung die Amplituden/Phasen-Ebene in Fenster eingeteilt wird, vollständig oder teilweise, und anschliessend dieses Raster auf die verschiedenen Prozesszustandsmatrizen jeweils zur Auswertung gewissermassen angewendet wird. Die Fenster können dabei beliebige Form und Grösse annehmen, und nebeneinander oder beabstandet angeordnet sein. Die Matrixelemente einzelner Fenster werden dann z.B. zusammengefasst behandelt, ggf. nach vorgängiger Mittelung, und die einzelnen korrespondierenden, in verschiedenen Prozesszustandsmatrizen angeordneten Fensterinhalte gewichtet verglichen. Konkret bedeutet dies, dass in der durch Phasenwinkel und Amplituden aufgespannten Ebene der Prozesszustandsmatrizen insbesondere (aber nicht zwingend) benachbart angeordnete Matrixelemente in diskreten Fenstern zusammengefasst werden, und dass die Matrixelemente jeweils eines Fensters gemeinsam gemittelt und/oder normiert werden, bevor sie dem Vergleichsverfahren zugeführt werden. Bevorzugt wird dabei so vorgegangen, dass die Inhalte korrespondierender Fenster unterschiedlicher Prozesszustandsmatrizen verglichen werden, und dass unterschiedliche Fenster in einer Prozesszustandsmatrix ggf. unterschiedlich gewichtet und/oder normiert werden.

Eine weitere Verbesserung oder Rationalisierung des Vergleichsverfahrens kann durch eine intelligente Auswahl besonders interessierender Bereiche realisiert werden. Dabei wird so vorgegangen, dass in der durch Phasenwinkel und Amplituden aufgespannten Ebene der Prozesszustandsmatrizen insbesondere benachbart angeordnete Matrixelemente in diskrete interessierende Bereiche zusammengefasst werden. Bevorzugt werden dann unterschiedliche diskrete interessierende Bereiche beim Vergleichsverfahren unterschiedlich normiert und/oder gewichtet. Die interessierenden Bereiche werden vorteilhafterweise so in Fenster beliebiger Form eingeteilt, dass die Fenster jeweils im wesentlichen den interessierenden Bereich abdecken. Konkret wird so vorgegangen, dass die diskreten interessierenden Bereiche in diskrete Fenster aufgeteilt werden, und dass die Inhalte von Fenstern von gleichen Bereichen, ggf. nach gemeinsamer Mittelung der Matrixelemente des jeweiligen Fensters, im Vergleichsverfahren gleich behandelt werden. Es kann auch die ganze Prozesszustandsmatrix als ein einziger gesamter interessierender Bereich definiert werden.

Grundsätzlich können unterschiedlichste Zustandsparameter berechnet und definiert werden. Ausserdem ist es möglich, aus den Vergleichen gewonnene Zustandsänderungen der aus interessierenden Bereichen gewonnenen Zustandsparameter mathematisch miteinander zu verknüpfen, um eine gewünschte Anzahl von Zustandsparametern zu erhalten. Auch ist es möglich, aus den Vergleichen gewonnene Zustandsänderungen der aus interessierenden Bereichen gewonnenen Zustandsparameter mathematisch mit wenigstens einem aus als nicht interessierend beurteilten Bereichen gewonnenem Zustandsparameter zu verknüpfen, um eine gewünschte Anzahl von Zustandsparametern zu erhalten.

Weitere bevorzugte Ausführungsformen des Verfahrens sind in den abhängigen Ansprüchen beschrieben.

Beliebige Prozesse können mit Hilfe des selben Verfahrens beurteilt werden, wobei der zeitlich Verlauf der Prozesse wie im Verfahren beschrieben dargestellt wird, und wobei deren Prozesszustände ebenfalls zur Abgabe einer zukünftigen Prognose dienen können bzw. aufgrund derer beliebige Massnahmen eingeleitet werden können, wenn die Prozesszustände sich in gleicher oder in ähnlicher Weise als Matrixelemente beschreiben lassen.

Ausserdem betrifft die vorliegende Erfindung eine Vorrichtung zur Durchführung des genannten Verfahrens.

### KURZE ERLÄUTERUNG DER FIGUREN

Die Erfindung soll nachfolgend anhand von Ausführungsbeispielen im Zusammenhang mit den Zeichnungen näher erläutert werden. Es zeigen:
- Fig. 1: das Teilentladungsverhalten eines elektrischen Betriebsmittel als phasenaufgelöstes Teilentladungsmuster (phase resolved partial discharge pattern, PRPD) zu zwei verschiedenen Zeitpunkten, links der bewertete Zustand, rechts ein späterer Zustand;
- Fig. 2: ein phasenaufgelöstes Teilentladungsmuster gemäss Figur 1, wobei die zweidimensionalen Ebenen in korrespondierende Fenster eingeteilt sind;
- Fig. 3: a) ein phasenaufgelöstes Teilentladungsmuster gemäss Figur 1, bewerteter Zustand links, wobei zwei interessierende Teilprozesse bezeichnet und in Fester eingeteilt sind; b) wie a), späterer Zeitpunkt;
- Fig. 4: phasenaufgelöste Teilentladungsmuster gemäss Figur 1, wobei die drei verschiedenen Phasen des elektrischen Betriebsmittels übereinander dargestellt sind, und wobei jeweils drei spätere Zeitpunkte, nach 14, 38, resp. 52 Monaten, dargestellt sind;
- Fig. 5: einen normierten Zustandsparameter als Funktion der Zeit für die drei Phasen eines elektrischen Betriebsmittels, wobei Ähnlichkeitswerte abgeleitet von Fenstern gemäss Fig. 2 verwendet wurden und wobei die phasenaufgelösten Teilentladungsmuster aus Figur 4 zugrunde liegen; und
- Fig. 6: einen normierten Zustandsparameter als Funktion der Zeit für die drei Phasen eines elektrischen Betriebsmittels, wobei Ähnlichkeitswerte abgeleitet von Fenstern in interessierenden Bereichen gemäss Fig. 3 verwendet wurden und wobei die phasenaufgelösten Teilentladungsmuster aus Figur 4 zugrunde liegen.

### WEGE ZUR AUSFÜHRUNG DER ERFINDUNG

Die Erfindung betrifft ein Verfahren zum Feststellen der zeitlichen Entwicklung von Entladungsphänomenen, die z.B. von Gaseinschlüssen innerhalb von Hochspannungsisolationen herrühren oder aber auch von Entladungen auf der Oberfläche solcher Isolationen. Diese Prozesse lassen sich unter anderem in Form von Mustern und Bildern beschreiben.

Die Erkennung dieser so genannten Teilentladungen (TE) ist die zur Zeit verbreitetste Möglichkeit, den Isolationszustand von Hochspannungsisolationen auch während des Betriebes zu erfassen. Dementsprechend kommt der Erfassung und der automatischen Bewertung von Teilentladungsmustern bzw. deren Änderung immer stärkere Bedeutung zu.

Die im Folgenden beschriebene Erfindung wird vornehmlich zur Beurteilung des Isolationszustandes aufgrund der Bewertung teilentladungsrelevanter Prozesse eingesetzt. Sie besitzt jedoch nach Anpassung an den jeweiligen Prozess ebenso für weitere Anwendungsgebiete Gültigkeit.

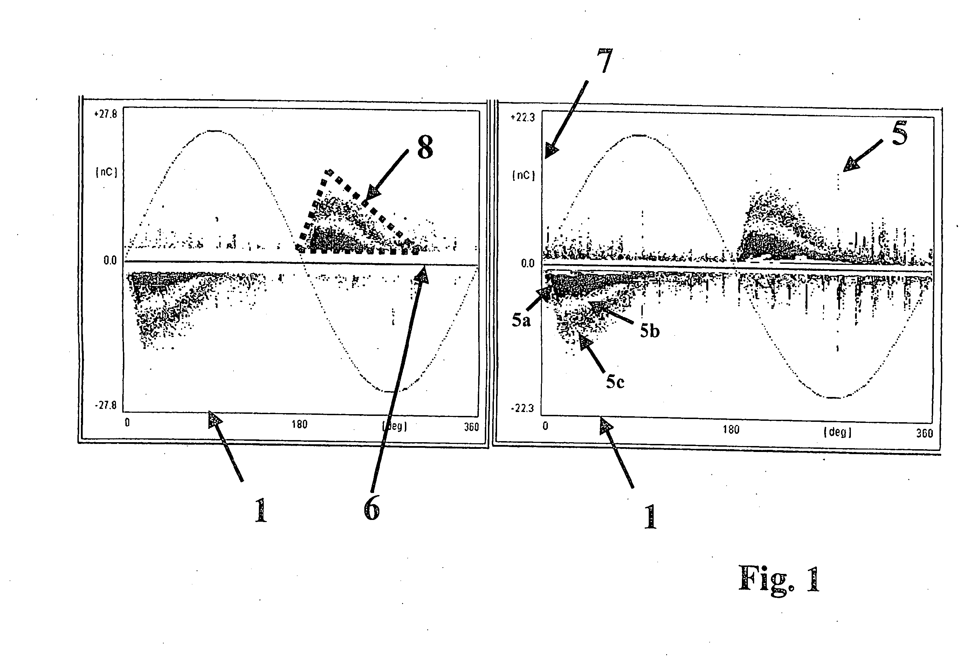

Fig. 1 zeigt das Teilentladungsverhalten eines elektrischen Betriebsmittels als sogenanntes Phasenaufgelöstes Teilentladungsmuster (PRPD pattern, Phase Resolved Partial Discharge pattern) 1, aufgenommen zu zwei verschiedenen Zeitpunkten 2 (gewissermassen bewerteter Referenzzustand) und 3 (später aufgenommener Zustand).

Diese Darstellung des Teilentladungsverhaltens als Bild ist etabliert und wird sehr häufig zur Beurteilung des Isolationszustandes herangezogen. Hierzu wird jedem Teilentladungsereignis ein Bildpunkt oder ein Matrixelement 5 in dieser Darstellung zugeordnet. Das geschieht nach folgender Konvention:
1. Der Phasenwinkel, bei welchem die Teilentladung aufgetreten ist, bildet die Abszisse 6.
2. Die Teilentladungsimpulsamplitude (Teilentladungsintensität) ist auf der Ordinaten 7 aufgetragen.
3. Die Anzahl der Teilentladungsereignisse (Auftretenshäufigkeit) werden in dem durch den Phasenwinkel und durch die Impulsamplitude aufgespannten Koordinatensystem farblich codiert abgebildet (Matrixelement, Pixel 5).

In den im folgenden dargestellten Diagrammen ist die farbliche Codierung leider nicht darstellbar. Bereiche unterschiedlicher Auftretenshäufigkeit sind aber versuchsweise durch unterschiedlich dicht gesetzte Bildpunkte visualisiert. In Fig. 1, rechter Teil ist dies erläutert: mit dem Bezugszeichen 5a ist der stark eingeschwärzte Bereich bezeichnet, welcher für eine hohe Auftretenshäufigkeit steht. In einer farbigen Darstellung wäre ein derartiger Bereich beispielsweise durch die Farbe gelb gekennzeichnet. Ein hellerer Bereich ist mit dem Bezugszeichen 5b gekennzeichnet, in diesem Bereich weisen die einzelnen Matrixelemente eine mittlere Auftretenshäufigkeit auf, und in einer farbigen Darstellung ist dieser Bereich beispielsweise rot codiert. Ausserdem ist mit dem Bezugszeichen 5c ein weiterer Bereich dargestellt, dessen Matrixelemente eine niedrige Auftretenshäufigkeit aufweisen. In einer farbigen Darstellung könnte dieser Bereich beispielsweise durch die Farbe violett codiert werden. Die leider im Zusammenhang mit der vorliegenden Beschreibung nicht mögliche farbige Darstellung erlaubt eine sehr intuitive und mit gleitenden Übergängen versehene Visualisierung der Daten, auf welche hier leider verzichtet werden muss. Da es sich aber bei der genannten Darstellung um eine an sich in diesem technischen Gebiet bekannte Art der Darstellung handelt, kann auf weitere Erläuterungen verzichtet werden.

Somit gelingt es, diese an sich dreidimensionale Datenmatrix zweidimensional zu visualisieren. Aus dieser zweidimensionalen Darstellung kann ein menschlicher Experte:
1. Teilentladungsquellen anhand gewisser Formen (typische Muster, in Figur 1 mit dem Bezugszeichen 8 dargestellt) ermitteln, die sich in diesem Bild ergeben.
2. Den Einfluss unterschiedlicher Belastungsparameter auf das Teilentladungsverhalten feststellen.
3. Veränderungen am bzw. innerhalb des Isolierstoffes anhand einer zeitlichen Abfolge aufgenommener Teilentladungsmessungen erkennen.
4. Anhand der oben beschriebenen Möglichkeiten kritische Zustände erkennen und weitere Massnahmen einleiten.

Da, wie im vorhergehenden Abschnitt "Stand der Technik" beschrieben, das Teilentladungsverhalten sowohl vom Betriebsmittel selbst als auch von der Peripherie des Betriebsmittels abhängt, kann allein aufgrund des oben beschriebenen Teilentladungsmusters nicht immer der Zustand der Isolation korrekt ermittelt werden. Folglich kommt der Ermittlung der Änderung des Teilentladungsverhaltens erhöhte Bedeutung zu.

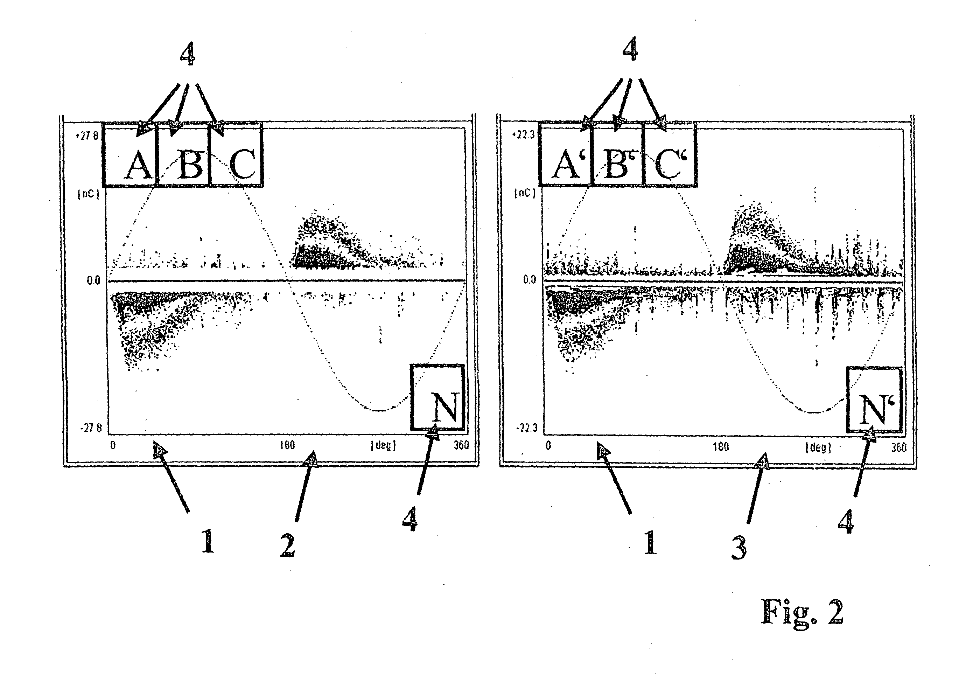

Die vorliegende Erfindung beschäftigt sich entsprechend mit dem Problem, den aktuellen Zustand 3 der Isolation eines elektrischen Betriebsmittels zu beurteilen. Die Beurteilung beruht auf dem Vergleich des aktuellen Zustandes 3 des Betriebsmittels mit einem früheren bekannten und bewerteten Zustand 2 des Betriebsmittels. In den Figuren 1 und 2 ist beispielsweise der frühere, bekannte und bewertete Zustand 2 auf der linken Seite dargestellt, und der spätere aktuelle Zustand 3 auf der rechten Seite. Hierbei kann die bisherige zeitliche Entwicklung (relative Änderung) auch für Prognosen des Zustandes in der Zukunft herangezogen werden.

Beschreibung eines ersten Ausführungsbeispiels des Verfahrens unter Verwendung der Fig. 2 zur Illustration:
1. Das Teilentladungsverhalten eines Betriebsmittels wird zu verschiedenen Zeitpunkten aufgenommen. Im Beispiel repräsentiert 2 das Verhalten zum Startzeitpunkt und 3 zum aktuellen Zeitpunkt.
2. Die als Bild visualisierten Teilentladungsverhalten werden gegenübergestellt (Fig. 2).
3. Beide zu verschiedenen Zeitpunkten aufgenommenen Bilder (Fig. 2) werden in eine gleiche Anzahl von Fenstern 4 unterteilt (A, B, C, ..., N; A', B', C', ..., N').
4. In jedem der Fenster wird eine Mittelwertbildung und Normierung der Bildpunkte durchgeführt, um unbedeutende Unterschiede zwischen den Fensterinhalten nicht dominant zu bewerten.
5. Die Bildinhalte werden Fenster für Fenster verglichen, wobei jeweils korrespondierende Fenster verglichen werden (Figur 2, Fenster A mit A', Fenster B mit B', Fenster C mit C', ....., Fenster N mit N').
6. Der Vergleich der einzelnen Fenster 4 ergibt sogenannte Ähnlichkeitswerte.
7. Die Ähnlichkeitswerte aller Fenster (Figur 2; A, B, C, .... N; A', B', C', ....N') werden zu einem einzelnen oder zu mehreren Ähnlichkeitswerten, für das gesamte Bild (Fig. 2 ; A, B, C, .... N ; A', B', C', .... N') repräsentativ, zusammengefasst.
8. Der initiale Zustandsparameter wird mit dem Ähnlichkeitswert korreliert, um einen aktuellen Zustandsparameter zu bilden.
9. Die zeitliche Entwicklung der Zustandsparameter kann z.B. dazu verwendet werden, Instandhaltungsarbeiten einzuleiten, oder die zukünftige zeitliche Entwicklung zu prognostizieren.

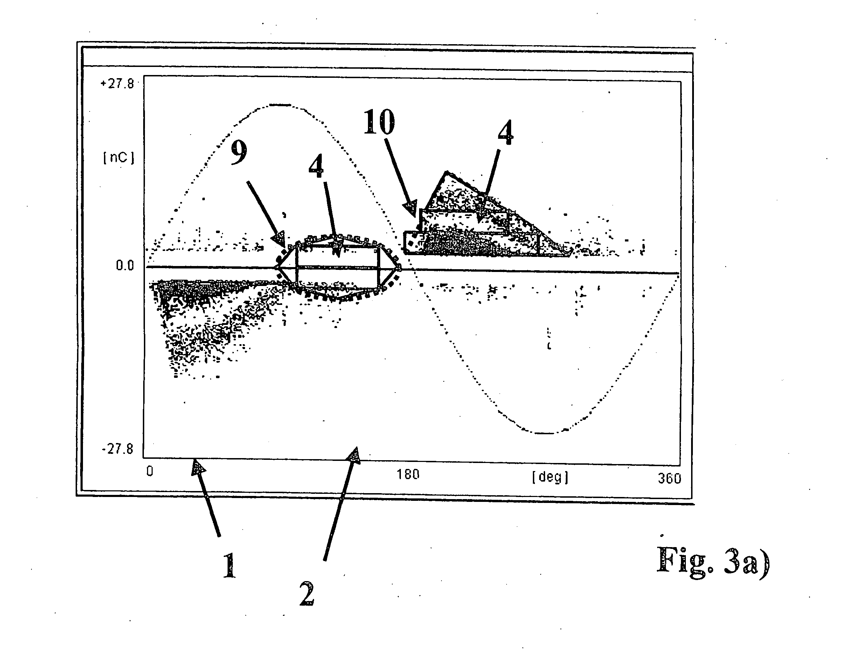

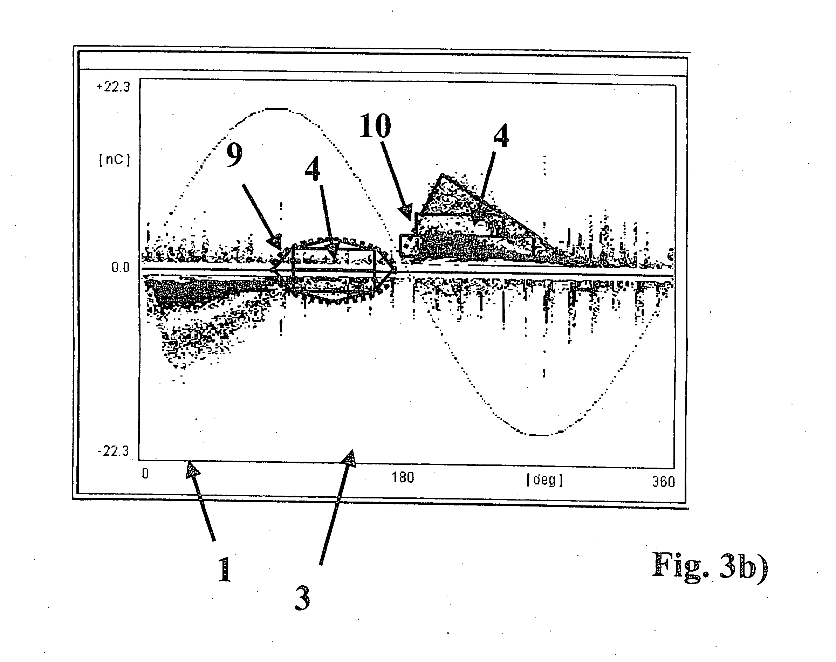

Beschreibung eines zweiten Ausführungsbeispiels des Verfahrens unter Verwendung der Fig. 3 zur Illustration:
1. Das Teilentladungsverhalten eines Betriebsmittels wird zu verschiedenen Zeitpunkten aufgenommen. Im Beispiel repräsentiert 2 das Verhalten zum Startzeitpunkt (Fig. 3a) und 3 zum aktuellen Zeitpunkt (Fig. 3b).
2. Im Bild 2 (Fig. 3a), das aus der ersten Messung resultiert, werden alle Bereiche markiert, auf die im folgenden Bildvergleich der spezielle Vergleichsalgorithmus angewendet werden soll (interessierende Teilprozesse 9, 10; sogenannte ROI's = "regions of interest", im weiteren Dokument immer als ROI abgekürzt). Idealerweise umschreiben diese ROI's Muster, die ihrerseits Teilentladungsorte repräsentieren können.
3. Die Anzahl der markierten ROI's kann beliebig hoch sein.
4. Die als Bild visualisierten Teilentladungsverhalten werden gegenübergestellt (Fig. 3a und b).
5. Die markierten ROI's werden in eine Anzahl von Fenstern 4 unterteilt, deren Formen/Grössen beliebig gewählt werden und welche die zuvor gekennzeichneten Teilbereiche 9 und 10 ausreichend gut nachbilden.
6. In jedem der Fenster wird eine Mittelwertbildung und Normierung der Bildpunkte durchgeführt, um unbedeutende Unterschiede zwischen den Fensterinhalten nicht dominant zu bewerten.
7. Die Bildinhalte werden Fenster 4 für Fenster 4 verglichen, wobei jeweils korrespondierende Fenster innerhalb der markierten Teilbereiche 9, 10 verglichen werden.
8. Der Vergleich der einzelnen Fenster 4 ergibt sogenannte Ähnlichkeitswerte.
9. Die Ähnlichkeitswerte aller Fenster 4 innerhalb der jeweiligen ROI 9, 10 werden zu einem einzelnen oder zu mehreren Ähnlichkeitswerten, für die jeweilige ROI 9 oder 10 repräsentativ, zusammengefasst. Die zusammengefassten Werte nennen sich Zustandsparameter.
10. Die gewonnenen Zustandsparameter der zum ersten Zeitpunkt 2 und der zum zweiten Zeitpunkt 3 ermittelten Teilentladungsverhalten werden miteinander korreliert, was hier als Zustandsänderung bezeichnet wird.
11. Der Ähnlichkeitswert ausserhalb aller, zum ersten Zeitpunkt 2 und zum zweiten Zeitpunkt 3 ermittelten Teilentladungsverhalten, markierten Fenster 4 wird ebenso gebildet, um die Zustandsänderungen auch ausserhalb der ROI Bereiche 9, 10 festzuhalten.
12. Die Zustandsparameter der Zustandsänderungen innerhalb der ROI und auch ebenso ausserhalb der ROI können als einzelner Zahlenwert oder durch mehrere Zahlenwerte repräsentiert werden.
13. Die zeitliche Entwicklung der Zustandsänderungen kann z.B. dazu verwendet werden, Instandhaltungsarbeiten einzuleiten, oder die zukünftige zeitliche Entwicklung zu prognostizieren.

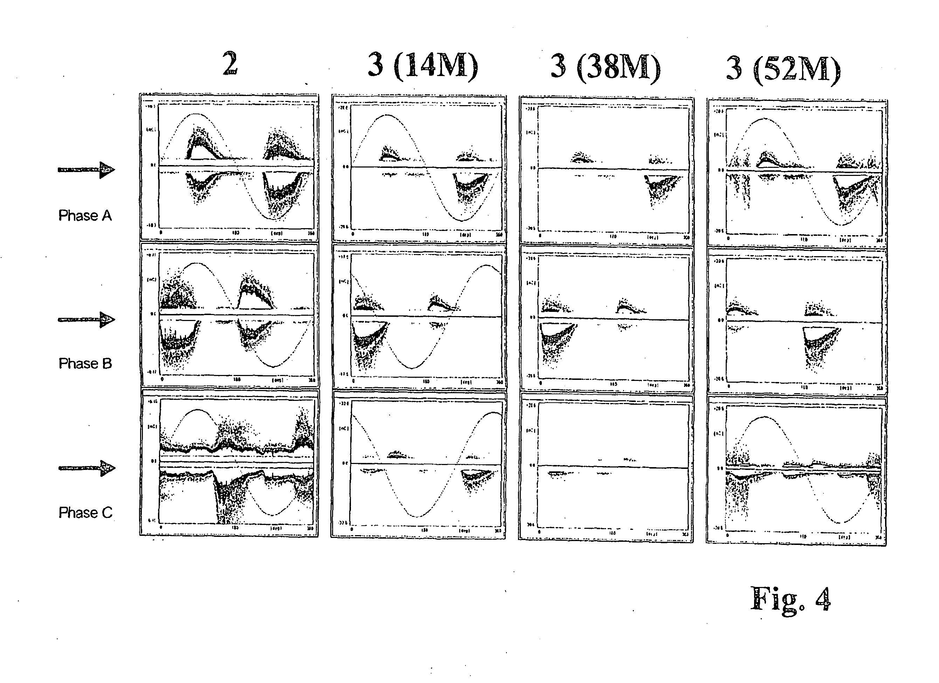

In Fig. 4 ist die zeitliche Entwicklung des Teilentladungsverhaltens eines Generators mit folgenden Betriebsdaten dargestellt:

| | |
|---|---|
| Inbetriebsetzung | 1975 |
| Nennleistung | 500 MVA |
| Nennspannung | 24 kV |
| Nennfrequenz | 60 Hz |
| Kühlart | H₂/H₂O |

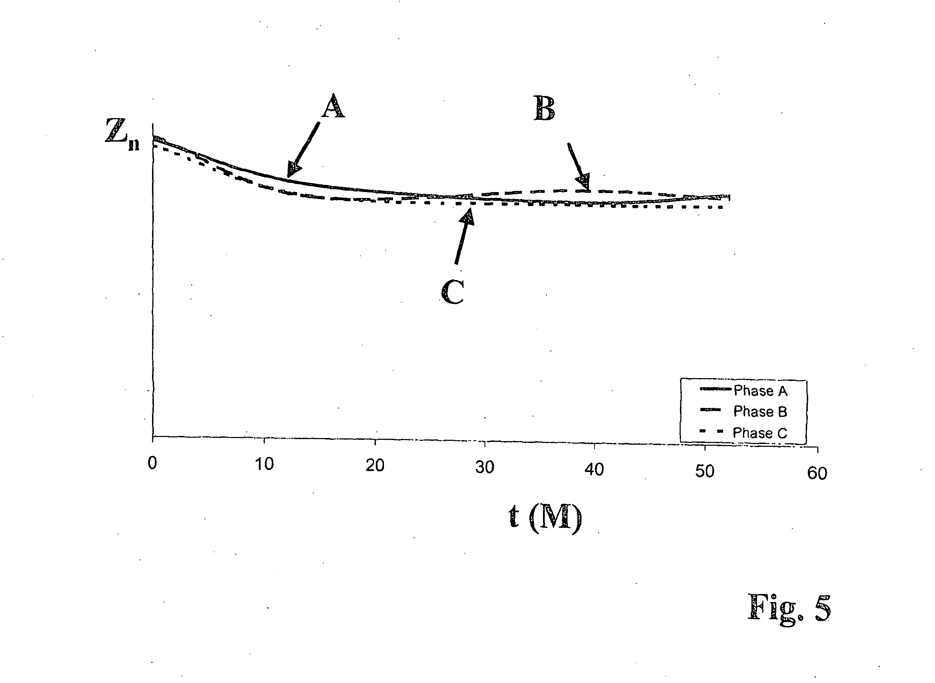

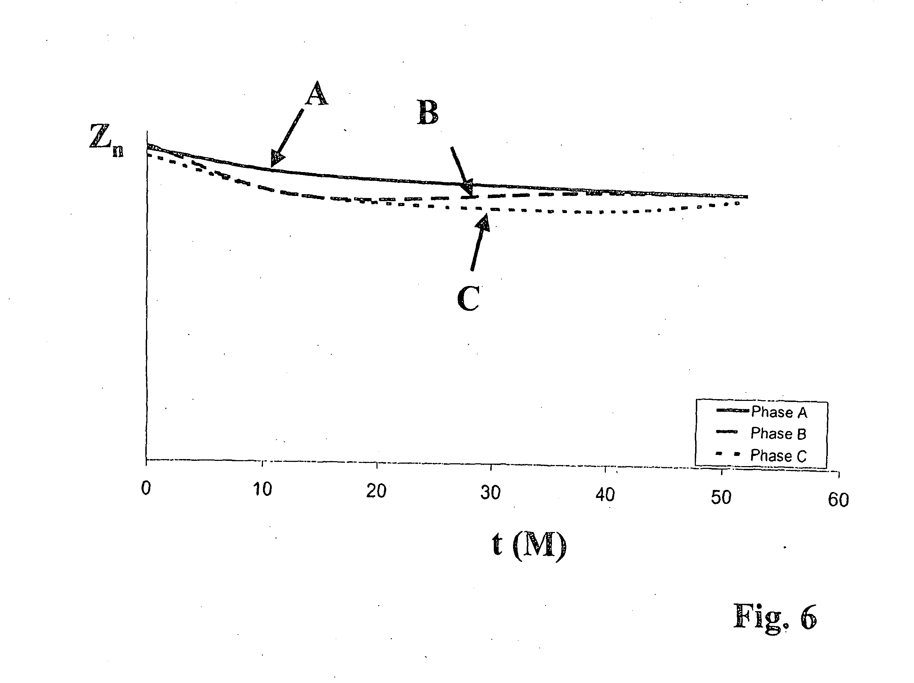

Das Teilentladungsverhalten aller drei Phasen A, B, und C wurde mit elektrischen Sensoren über einen Zeitraum von über 50 Monaten regelmässig aufgenommen, Figur 4 zeigt hierbei eine Auswahl gemessener Teilentladungsmuster, Figur 5 zeigt die daraus gewonnenen Zustandsparameter Zₙ über diesen Zeitraum, wenn ein Verfahren wie in Figur 2 dargestellt, verwendet wird. Fig. 6 zeigt die daraus gewonnenen Zustandsparameter Zₙ über diesen Zeitraum, wenn ein Verfahren wie in Fig. 3 dargestellt verwendet wird, wobei die Zustandsänderungen aller zuvor markierten interessierenden Teilbereiche zu einem gesamten Zustandsparameter zusammengefasst wurden, und alle als interessierend markierten Bereiche gleich gewichtet wurden.

Das erste gemessene Teilentladungsmuster jeder Phase wurde zur Gewinnung des bewerteten Zustandsparameters herangezogen, die Zustandsänderung bezieht sich hiermit immer auf Basis dieser ersten bewerteten Messung.

Die Veränderung des Teilentladungsverhaltens bis zu ca. 10 Monaten wurde durch ergänzende diagnostische Untersuchungen und auch durch visuelle Befunde belegt. Das spätere konstante Verhalten lässt darauf schliessen, dass die Isolation dieses elektrischen Betriebsmittels stabiles Verhalten zeigen wird.

Als wesentlicher Unterschied zu den bereits bekannten Verfahren (siehe Kapitel "Stand der Technik") sind zu nennen:
1. Der zeitliche Unterschied zwischen zwei Prozesszuständen, die Zustandsparameter, werden als einfacher Zahlenwert, oder als Satz von Zahlenwerten, dargestellt.
   Daraus resultiert ein geringer Aufwand für die Speicherung des Ähnlichkeitswertes, der den Unterschied zwischen beiden Prozesszuständen repräsentiert.
   Somit sind auch Vergleiche der Prozesszustände in sehr kurzen zeitlichen Abständen möglich, da die Datenmenge gering ist.
2. Der Zustand des Betriebsmittels muss zu keinem der Zeitpunkte 2, 3 zwingend bekannt sein, da nur die zeitliche Änderung der Zustandsparameter erfasst wird.
3. Verknüpft mit dem resp. den zum ersten Zeitpunkt 2 bewerteten Zustandsparameter(n) kann der tatsächliche Isolationszustand abgeschätzt werden. Aufgrund der verknüpften Werte können zukünftige Isolationszustände abgeschätzt werden und gegebenenfalls Massnahmen ergriffen werden, kritische Zustände zu erkennen und zu vermeiden.
4. Die Zustandsänderung wird für das Betriebsmittel mit sich selbst ermittelt. Es erfolgt kein Vergleich mit anderen Betriebsmitteln, die unter Umständen ähnliches Verhalten zeigen könnten. Diese Verknüpfung geschieht bei der erstmaligen Bewertung des Zustandes zu einem gewählten Zeitpunkt 2.
5. Die Grösse, Form und Anzahl der interessierenden Teilbereiche 9, 10 können beliebig gewählt werden, um die Vergleichsprozesse auf den zugrunde liegenden Teilentladungsprozess zu optimieren.
6. Die Grösse, Form und Anzahl der Fenster 4, welche in die interessierende Teilbereiche 9, 10 (oder auch in die gesamte Ebene) eingeschrieben werden, und die diese Teilbereiche mathematisch beschreiben, können beliebig gewählt werden, um die Vergleichsprozesse auf den zugrunde liegenden Teilentladungsprozess zu optimieren.
7. Die Gewinnung des bewerteten Zustandes resp. der bewerteten Zustände zum gewählten Zeitpunkt 2 basiert auf die Erfahrung des "Human Expert", der diese Bewertung durchführt. Daher ist die zugrundeliegende "Erfahrungsbasis" beliebig gross.
8. Die zur Gewinnung der bewerteten Zustände zum gewählten Zeitpunkt 2 zugrunde liegende "Erfahrungsbasis" besteht aus allen grundlegenden Erfahrungen bzgl. Teilentladungsverhalten, Konstruktionsmerkmalen, typisches Lastverhalten, typische Fehlerorte, etc.
9. Die Grösse der Fenster 4, in welche die Bilder 1, 2, 3 für den Vergleich unterteilt werden (insbesondere bei einem Verfahren gem. Fig. 2), kann beliebig gewählt werden, um den Vergleichsprozess auf den zugrunde liegenden Prozess zu optimieren.
10. Die Form der Fenster 4, in welche die Bilder 1, 2, 3 für den Vergleich unterteilt werden (insbesondere bei einem Verfahren gem. Fig. 2), kann beliebig gewählt werden, um den Vergleichsprozess auf den zugrunde liegenden Prozess zu optimieren.
11. Die Wahl der interessierenden Bereiche 9, 10 zum gewählten Zeitpunkt 2 bei einem Verfahren gem. Fig. 3 basiert auf die Erfahrung des "Human Expert", der die Markierung dieser interessierenden Bereiche 9 und 10 durchführt. Daher ist die zugrundeliegende "Erfahrungsbasis" beliebig gross.
12. Bei der Ermittlung der Ähnlichkeitswerte können beliebige Gewichtungen und Normierungen nach definierten Kriterien eingeführt werden (Bspw. Gewichtung der Amplitude 7 oder der Teilentladungsanzahl je Bildpunkt 5 oder auch Gewichtung des Phasenwinkels 6).
13. Jeder markierte Teilbereich 9, 10 kann individuell gewichtet werden, um dem tatsächlichen Schädigungsprozess besser Rechnung zu tragen.
14. Durch die gesonderte Bewertung der Änderung der Zustandsparameter ausserhalb der als interessierend gekennzeichneten Bereiche 9, 10 bzw. ausserhalb der sie mathematisch beschreibenden Fenster 4 werden auch Änderungen im Teilentladungsprozess erkannt, die zum (bewerteten) ersten Zeitpunkt 2 nicht als bedeutsam erachtet wurden, oder wo keine Teilentladungsprozesse erkennbar waren.
15. Bei dem Verfahren gem. Fig. 3 ist durch die gesonderte Behandlung von gekennzeichneten Bereichen und nicht gekennzeichneten Bereichen keine oder nur geringe Störsignalunterdrückung notwendig.

### BEZUGSZEICHENLISTE

- 1: Prozesszustands - Matrix, visualisiert als Bild in Pixel
Darstellung, z.B. 256 Pixel x 256 Pixel
- 2: Prozesszustand, zum ersten Zeitpunkt; bewerteter Zustand
- 3: Prozesszustand, zum späteren Zeitpunkt
- 4: Fenster
- 5: Matrixelement / Pixel (Bildpunkt)
- 5a: Matrixelement mit hoher Auftretenshäufigkeit
- 5b: Matrixelement mit mittlerer Auftretenshäufigkeit
- 5c: Matrixelement mit niedriger Auftretenshäufigkeit
- 6: Abszisse; x-Koordinate (Phasenwinkel des Auftretens der Teilentladung)
- 7: Ordinate; y-Koordinate (Teilentladungsimpulsamplitude)
- 8: Muster
- 9: Erster interessierender Teilprozess, erster interessierender Bereich (region of interest, ROI)
- 10: Zweiter interessierender Teilprozess, zweiter interessierender Bereich (region of interest, ROI)
- Zₙ: Zustandsparameter

## Patentansprüche

1. Verfahren zur Analyse des Teilentladungsverhaltens eines elektrischen Betriebsmittels in dessen zeitlicher Entwicklung, wobei entsprechende Teilentladungsdaten in Prozesszustandsmatrizen (1) festgehalten werden, in welchen jeweils in einem Matrixelement (5) der Prozesszustandsmatrix (1) die Amplitude (7) einer Teilentladung, deren Phasenwinkel (6) und deren Auftretenshäufigkeit abgebildet ist,
**dadurch gekennzeichnet, dass**
zu einem ersten Zeitpunkt ein Teilentladungsprozesszustand in einer ersten Prozesszustandsmatrix (2) erfasst wird, und zu einem späteren Zeitpunkt ein weiterer Teilentladungsprozesszustand in einer weiteren Prozesszustandsmatrix (3) erfasst wird, dass
zur Analyse die erste (2) und die zweite (3) Prozesszustandmatrix unter Zuhilfenahme von Vergleichs- und Normierungsverfahren verglichen werden, und dass
jeweils in einem Matrixelement (5) der Prozesszustandsmatrix (1) die Amplitude (7) einer Teilentladung als Funktion des Phasenwinkels (6) abgebildet ist, und jedem Matrixelement (5) ausserdem eine zugehörige Auftretenshäufigkeit zugeordnet ist,
wobei in den Prozesszustandsmatrizen (2,3) benachbart angeordnete Matrixelemente (5) in einer jeweils gleichen Zahl von N diskreten Fenstern (4) zusammengefasst werden,
wobei die Matrixelemente (5) jeweils eines Fensters (4) gemeinsam gemittelt und normiert werden, bevor sie dem Vergleichverfahren zugeführt werden,
wobei die Fenster in der durch Phasenwinkel (6) und Amplituden (7) aufgespannten Ebene festgelegt werden und diese Ebene vollständig abdecken,
wobei die gemittelten und normierten Inhalte der jeweils korrespondierenden Fenster in der ersten (2) und der weiteren Prozesszustandsmatrix (3) verglichen werden, indem Ähnlichkeitswerte gebildet werden, **dadurch gekennzeichnet, dass**
die Ähnlichkeitswerte aller Fenster (4) zu einem einzelnen normierten Zustandsparameter (Zₙ) für das gesamte Bild der durch Phasenwinkel (6) und Amplituden (7) aufgespannten Ebene zusammengefasst werden, und diese normierten Zustandsparameter (Zₙ) anschliessend zur Analyse der Isolationszustände (2,3) verglichen werden, indem der zeitliche Verlauf von aus verschiedenen weiteren Prozesszustandsmatrizen (3) ermittelten Zustandsparametern (Zₙ) zur Bewertung der zeitlichen Änderung respektive der Prognose der weiteren zeitlichen Änderung des Teilentladungsverhaltens hinzugezogen wird und dass
die einzelnen Matrixelemente (5) je nach Amplitude (7) oder je nach Phasenwinkel (6) oder je nach Auftretenshäufigkeit eine unterschiedliche Gewichtung und/oder Normierung erfahren, bevor sie dem Vergleichs- und Normierungsverfahren zugeführt werden.

2. Verfahren nach Anspruch 1, **dadurch gekennzeichnet, dass** aus den Vergleichen gewonnene Zustandsänderungen der aus interessierenden Bereichen (9,10) gewonnenen Zustandsparameter mathematisch verknüpft werden, um eine gewünschte Anzahl von Zustandsparametern zu erhalten.

3. Verfahren nach einem der Ansprüche 1 oder 2, **dadurch gekennzeichnet, dass** aus den Vergleichen gewonnene Zustandsänderungen der aus interessierenden Bereichen (9,10) gewonnenen Zustandsparameter mathematisch mit
wenigstens einem aus anderen Bereichen gewonnenen Zustandsparameter verknüpft werden, um eine gewünschte Anzahl von Zustandsparametern zu erhalten.

## Claims

1. Method for the analysis of the partial discharge behavior of an electrical operating means in terms of its development over time, appropriate partial discharge data being recorded in process state matrices (1), in which the amplitude (7) of a partial discharge, its phase angle (6) and its frequency of occurrence is depicted in each case in a matrix element (5) of the process state matrix (1), **characterized in that**
at a first time, a partial discharge process state is registered in a first process state matrix (2) and, at a later time, a further partial discharge process state is registered in a further process state matrix (3), **in that**
for the purpose of analysis, the first (2) and the second (3) process state matrix are compared with the aid of comparison and normalization methods, and **in that**
in each case in a matrix element (5) of the process state matrix (1), the amplitude (7) of a partial discharge is depicted as a function of the phase angle (6), and each matrix element (5) is additionally assigned an associated frequency of occurrence,
in the process state matrices (2, 3), adjacently arranged matrix elements (5) being combined in a number, which is identical in each case, of N discrete windows (4),
the matrix elements (5) of a respective window (4) being averaged and normalized together before they are supplied to the comparison method,
the windows being defined in the plane covered by phase angles (6) and amplitudes (7) and completely covering this plane,
the averaged and normalized contents of the respectively corresponding windows in the first (2) and the further process state matrix (3) are compared by similarity values being formed,
**characterized in that**
the similarity values of all the windows (4) are combined to form an individual normalized state parameter (Zₙ) for the entire image of the plane covered by phase angles (6) and amplitudes (7), and these normalized state parameters (Zₙ) are then compared for the purpose of analysis of the insulation states (2, 3) by the variation over time of state parameters (Zₙ) determined from various further process state matrices (3) additionally being used for the assessment of the change over time or for the prognosis of the further change over time of the partial discharge behavior, and **in that**
the individual matrix elements (5), depending on the amplitude (7) or depending on the phase angle (6) or depending on the frequency of occurrence, are subjected to different weighting and/or normalization before they are supplied to the comparison and normalization method.

2. Method according to Claim 1, **characterized in that** state changes obtained from the comparisons of the state parameters obtained from regions (9, 10) of interest are linked mathematically in order to obtain a desired number of state parameters.

3. Method according to either of Claims 1 and 2, **characterized in that** state changes obtained from the comparisons of the state parameters obtained from regions (9, 10) of interest are linked mathematically with at least one state parameter obtained from other regions, in order to obtain a desired number of state parameters.

## Revendications

1. Procédé d'analyse du comportement de décharge partielle d'un moyen d'entraînement électrique dans son développement temporel, dans lequel des données appropriées de décharge partielle sont conservées dans des matrices (1) d'état de processus dans lesquelles l'amplitude (7) de chaque décharge partielle, son angle de phase (6) et sa fréquence d'apparition sont représentées dans un élément respectif (5) de la matrice (1) d'état de processus,
**caractérisé en ce que**
à un premier instant, un état du processus de décharge partielle est saisi dans une première matrice (2) d'état de processus et à un instant ultérieur, un autre état du processus de décharge partielle est saisi dans une autre matrice (3) d'état du processus,
**en ce que** pour l'analyse, la première matrice (2) et la deuxième matrice (3) d'état du processus sont comparées à l'aide de procédures de comparaison et de normalisation,
**en ce que** dans chaque élément (5) de la matrice (1) d'état du processus, l'amplitude (7) d'une décharge partielle est représentée en fonction de l'angle de phase (6) et **en ce que** la fréquence d'apparition associée est de plus attribuée à chaque élément de matrice (5),
**en ce que** des éléments (5) voisins dans les matrices (2, 3) d'état du processus sont rassemblés dans un même nombre N de fenêtres distinctes (4),
**en ce que** la moyenne des éléments (5) de matrice de chaque fenêtre (4) est formée et ces éléments sont normés avant d'être amenés à la procédure de comparaison,
**en ce que** les fenêtres sont définies dans le plan sous-tendu par les angles de phase (6) et les amplitudes (7) et recouvrent complètement ce plan,
**en ce que** les contenus moyennés et normés de chaque fenêtre correspondante de la première matrice (2) et de la deuxième matrice (3) d'état du processus sont comparés en formant des valeurs de similitude, **caractérisé en ce que**
les valeurs de similitude de toutes les fenêtres (4) sont rassemblées en un paramètre normé unique d'état (Zₙ) pour l'ensemble de la représentation du plan sous-tendu par les angles de phase (6) et les amplitudes (7) et ces paramètres d'état normés (Zₙ) sont ensuite comparés pour analyser des états d'isolation (2, 3) en intégrant l'évolution temporelle de paramètres d'état (Zₙ) déterminés sur d'autres matrices (3) différentes d'état du processus pour évaluer la modification temporelle ou le pronostic de la poursuite de la modification temporelle du processus de décharge partielle et
**en ce qu'**avant d'être amenés à la procédure de comparaison et de normalisation, les différents éléments (5) de matrice reçoivent une pondération et/ou une normalisation différentes selon l'amplitude (7), l'angle de phase (6) ou la fréquence d'apparition.

2. Procédé selon la revendication 1, **caractérisé en ce que** les modifications d'état, obtenues par la comparaison, des paramètres d'état obtenus sur des zones (9, 10) étudiées sont associées mathématiquement pour obtenir un nombre souhaité de paramètres d'état.

3. Procédé selon l'une des revendications 1 ou 2, **caractérisé en ce que** les modifications d'état, obtenues par la comparaison, des paramètres d'état obtenus sur les zones (9, 10) étudiées sont associées mathématiquement à au moins un paramètre d'état obtenu sur d'autres zones pour obtenir un nombre souhaité de paramètres d'état.
